(19) **Europäisches Patentamt / European Patent Office / Office européen des brevets**

(11) **EP 2 479 900 A1**

(12) **EUROPEAN PATENT APPLICATION**
published in accordance with Art. 153(4) EPC

(43) Date of publication:
**25.07.2012 Bulletin 2012/30**

(21) Application number: **10817021.8**

(22) Date of filing: **24.08.2010**

(51) Int Cl.:
**H04B 1/26** (2006.01)   **H03J 5/02** (2006.01)
**H04B 1/10** (2006.01)   **H04B 1/18** (2006.01)

(86) International application number:
**PCT/JP2010/064296**

(87) International publication number:
**WO 2011/033908 (24.03.2011 Gazette 2011/12)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **18.09.2009 JP 2009216484**

(71) Applicant: **Mitsumi Electric Co., Ltd.
Tama-shi
Tokyo 206-8567 (JP)**

(72) Inventors:
• **SHIMIZU, Nobutaka
Tama-Shi
Tokyo 206-8567 (JP)**
• **YASHIMA, Kiminori
Tama-Shi
Tokyo 206-8567 (JP)**

(74) Representative: **Collin, Jérôme
Cabinet Regimbeau
20, rue de Chazelles
75847 Paris Cedex 17 (FR)**

(54) **SUPERHETERODYNE RECEIVER APPARATUS AND RECEPTION METHOD, AND SEMICONDUCTOR INTEGRATED CIRCUIT FOR RECEIVER APPARATUS**

(57)    A superheterodyne receiver apparatus includes a tuning circuit for selecting and receiving a high frequency signal, the circuit being composed of a voltage-variable capacitance element and an inductance element; and a frequency converting unit for frequency converting the high frequency signal to an intermediate frequency signal. The superheterodyne receiver apparatus further includes an electrically rewritable read only memory; a calculation unit for calculating tuning voltage setting data, which are used to set the tuning circuit to a tuning voltage corresponding to a desired reception frequency, in accordance with a mathematical expression that uses the data stored in the memory as coefficients; and a D/A conversion unit for D/A converting the tuning voltage setting data to the tuning voltage.

FIG.1

**Description**

TECHNICAL FIELD

The present invention relates to a superheterodyne receiver apparatus, a superheterodyne receiving method, and a semiconductor integrated circuit for the superheterodyne receiver apparatus.

BACKGROUND ART

If tuning digital data are input to a tuning voltage generating circuit such as a DA converter, an analog voltage corresponding to the input tuning digital data is output. The output analog voltage is supplied to a variable capacitance diode of a tuning circuit via a resistor as a backward voltage.

The capacitance value of the variable capacitance diode is changed by the backward voltage. The variable capacitance diode resonates with an inductor connected in parallel with the variable capacitance diode, to thereby function as a bandpass filter which selects a RF signal and makes the selected RF signal pass through.

As described, in order to accurately control the resonance frequency of the bandpass filter, i.e., the tuning frequency of the tuning circuit, the tuning digital data to be input to the tuning voltage generating circuit becomes necessary for each receiver frequency.

For example, the number of receiver frequencies received by a broadcast receiver become several hundreds to several thousands. In order to prepare tuning digital data for tuning all these frequencies and store the tuning digital data in a memory, the memory preferably has a great capacity. In this case, the cost of the memory becomes high. Further, time and an effort for calculating and storing the data become great.

Patent Document 1 discloses that only several tuning digital data sets for several receiver frequencies are stored in a memory, and the tuning digital data sets for receiver frequencies which are not stored are presumed from the stored tuning digital data.

[Patent Document 1] Japanese Laid-open Patent Publication No. H05-48392

DISCLOSURE OF THE INVENTION

PROBLEMS TO BE SOLVED BY THE INVENTION

With the method of presuming the tuning digital data for receiver frequencies which are not stored, if a relationship between the receiver frequency and the tuning digital data is expressed by a linear line, the tuning digital data for receiver frequencies which are not stored can be calculated from two receiver frequencies and two tuning digital data sets corresponding to the two receiver frequencies.

For example, if tuning digital data for a receiver frequency F1 are D1 and tuning digital data for a receiver frequency F2 are D2, a relationship between receiver frequency Fa desired to be calculated and tuning digital data Da is expressed by a primary (linear) expression of the Formula 1, shown below.

Formula 1

$$D_a = \frac{D_2 - D_1}{F_2 - F_1}(F_a - F_1) + D_1 \qquad \cdots (1)$$

However, in the above conventional method, the tuning digital data Da corresponding to the receiver frequency Fa cannot be calculated without the digital data indicative of the receiver frequencies and the tuning digital data corresponding to the receiver frequencies being associated (paired) and stored in the memory. Further, the tuning digital data Da corresponding to receiver frequency Fa desired to be received need to be calculated by Formula 1 based on the read four values and the receiver frequency Fa after reading the four values $F_1$, $D_1$, $F_2$ and $D_2$ from the memory. Therefore, the process that occurs until the tuning digital data Da corresponding to the receiver frequency Fa desired to be received are calculated is complicated. Therefore, a desired receiver frequency may not be easily found by tuning.

Accordingly, embodiments of the present invention may provide a novel and useful superheterodyne receiver apparatus, a superheterodyne receiving method and a semiconductor integrated circuit for superheterodyne receiver apparatus, with which the desired receiver frequency is easily tuned.

MEANS FOR SOLVING PROBLEMS

In order to achieve the above object, one aspect of the present invention may be to provide a superheterodyne receiver apparatus including a tuning circuit including a voltage-variable capacitance element and an inductance element for selecting a high frequency signal and receiving the selected high frequency signal; a frequency converting unit configured to convert the high frequency signal to an intermediate frequency signal; an electrically rewritable read only memory configured to electrically rewrite data; a calculation unit configured to calculate tuning voltage setting data for setting a tuning voltage corresponding to a desired receiver frequency using a formula whose coefficients are the data in the electrically rewritable read only memory; and a D/A conversion unit configured to convert the tuning voltage setting data to the tuning voltage.

Another aspect of the present invention may be to provide a superheterodyne receiving method used for converting a high frequency signal to an intermediate frequency including calculating tuning voltage setting data for setting a tuning voltage corresponding to a desired receiver frequency using a formula whose coefficients are data in an electrically rewritable read only memory; and converting the tuning voltage setting data to the tuning voltage.

Another aspect of the present invention may be to provide a semiconductor integrated circuit for a superheterodyne receiver apparatus that includes a tuning circuit including a voltage-variable capacitance element and an inductance element for selecting high frequency signals and receiving the selected high frequency signal, and plural frequency converting units configured to convert the high frequency signal to intermediate frequency signals, the frequency converting units being integrated, including: an electrically rewritable read only memory configured to electrically rewrite data; a calculation unit configured to calculate tuning voltage setting data for setting a tuning voltage corresponding to a desired receiver frequency using a formula whose coefficients are the data in the electrically rewritable read only memory; and a D/A conversion unit configured to convert the tuning voltage setting data to the tuning voltage.

EFFECT OF THE INVENTION

According to an embodiment of the present invention, it is possible to easily tune to the desired receiver frequency.

BRIEF DESCRIPTION OF DRAWINGS

FIG. 1 is a block chart illustrating structures of a receiving IC 80 of the embodiment of the present invention and a receiver 10 being a receiver apparatus including the receiving IC 80 of the embodiment.
FIG. 2 illustrates a compensation circuit for temperature compensation.
FIG. 3 is a flowchart illustrating an exemplary receiving method of the embodiment of the present invention.
FIG. 4 illustrates a relationship between a receiver frequency and tuning voltage setting data.
FIG. 5 is a block chart illustrating an exemplary structure of a demodulating circuit 25.
FIG. 6 is a block chart illustrating an exemplary structure of a FM receiver 110.

BEST MODE FOR CARRYING OUT THE INVENTION

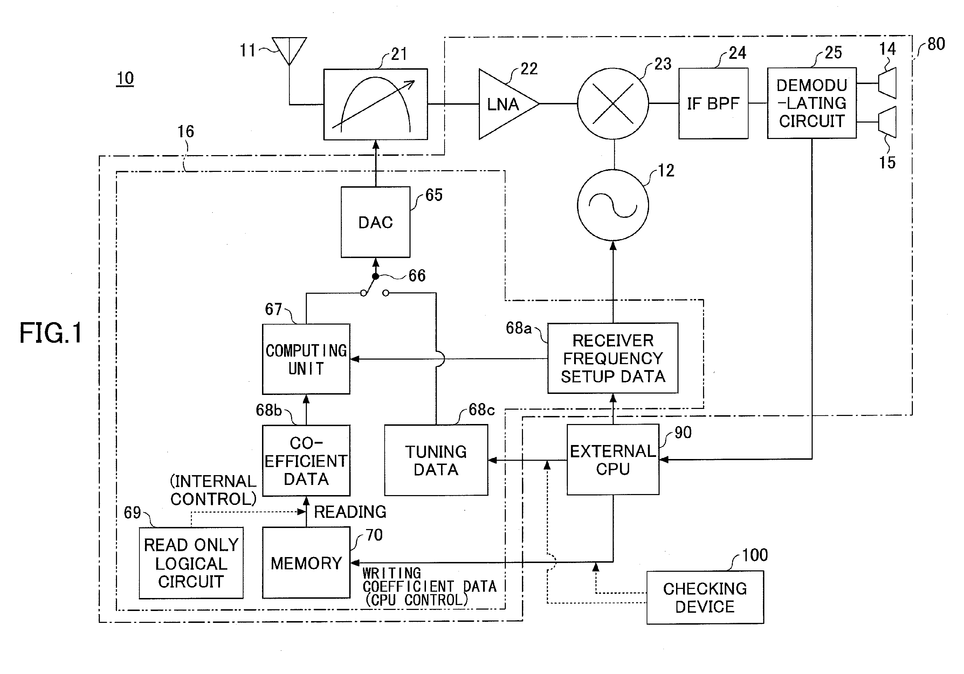

A description is given below, with reference to FIG. 1 through FIG. 6 of embodiments of the present invention.
FIG. 1 is a block chart illustrating structures of the receiving IC 80 of the embodiment and the receiver 10 being the receiver apparatus including the receiving IC 80 of the embodiment.
The receiver 10 is a superheterodyne receiver apparatus (a tuner module) including a voltage-variable capacitance element for selecting a high frequency signal, a tuning circuit 21 including an inductance element, and a frequency converting unit converting a high frequency signal (a RF signal) to an intermediate frequency signal (an IF signal). As shown in FIG. 1, the receiving IC 80 is a constitutional element of the receiver 10. An integrated frequency converting unit for converting a received high frequency signal (an RF signal) to an intermediate frequency signal (an IF signal) is included in the receiving IC 80. FIG. 1 exemplifies a FM mixer 23, a local oscillating circuit 12, and a bandpass filter 24 as major components of the frequency converting unit.
The receiving IC 80 includes a memory 70, a computing unit 67, and a DA converter 65. The computing unit 67 calculates tuning voltage setting data (digital data for tuning) for setting a tuning voltage corresponding to the desired receiver frequency in the tuning circuit 21 in conformity with a formula using data stored in the memory 70 as a coefficient. The DA converter 65 is a D/A conversion unit for converting the tuning voltage setting data calculated by the computing unit 67 to the tuning voltage (an analog voltage) corresponding to the desired receiver frequency.

Because the receiver 10 and the receiving IC 80 are structured as described above, a process of calculating the tuning voltage setting data corresponding to the desired receiver frequency can be simplified more than ever. Thus, the desired receiver frequency can be easily tuned to.

With the conventional method described above, it is necessary to previously store plural data sets combining the digital data indicative of the receiver frequency and the tuning digital data indicative of the receiver frequency in the memory. Further, and Formula 1 used to calculate the tuning digital data corresponding to the desired receiver frequency is complicated. Therefore, an arithmetic device such as an external CPU 90 relative to the receiving IC 80 illustrated in FIG. 1 calculates the tuning digital data corresponding to the desired receiver frequency. The external arithmetic device reads the combined data from an electrically rewritable read only memory every time the desired receiver frequency is changed, and calculates the tuning digital data corresponding to the desired receiver frequency to thereby give the calculated tuning digital data to the receiving IC.

Meanwhile, in the embodiment, since the coefficient data of the formula for calculating the tuning voltage setting data (i.e., the tuning digital data), not the combined data in the conventional technique, are stored in the memory, the formula (e.g., Formula 5 below) for calculating the tuning digital data corresponding to the desired receiver frequency based on the coefficient data can be simplified. Therefore, the tuning digital data corresponding to the desired receiver frequency need not be calculated by the external arithmetic device (e.g., the external CPU 90) of the receiving IC 80. Therefore, the receiving IC 80 itself may read the coefficient data from an internal memory inside the receiving IC 80 only once to calculate the tuning voltage setting data corresponding to the desired receiver frequency by using the computing unit inside the receiving IC 80. Said differently, the tuning voltage setting data corresponding to the desired receiver frequency may be calculated in conformity with the formula in which coefficient data, which are read from the memory, are used. As described, since the process until the tuning voltage setting data corresponding to the desired receiver frequency is calculated is simplified in comparison with the conventional technique, it is possible to easily tune to the desired receiver frequency.

With the conventional method, a degree of dependence on the external arithmetic device and its software increases in reading the data from the memory and calculating the tuning digital data.

On the contrary, with the embodiment, it is possible to avoid the dependence on the external arithmetic device and its software, since the tuning digital data can be calculated by the computing unit 67 of the receiving IC 80. Therefore, the time and cost for designing the software can be reduced and it is possible to easily tune to the desired receiver frequency.

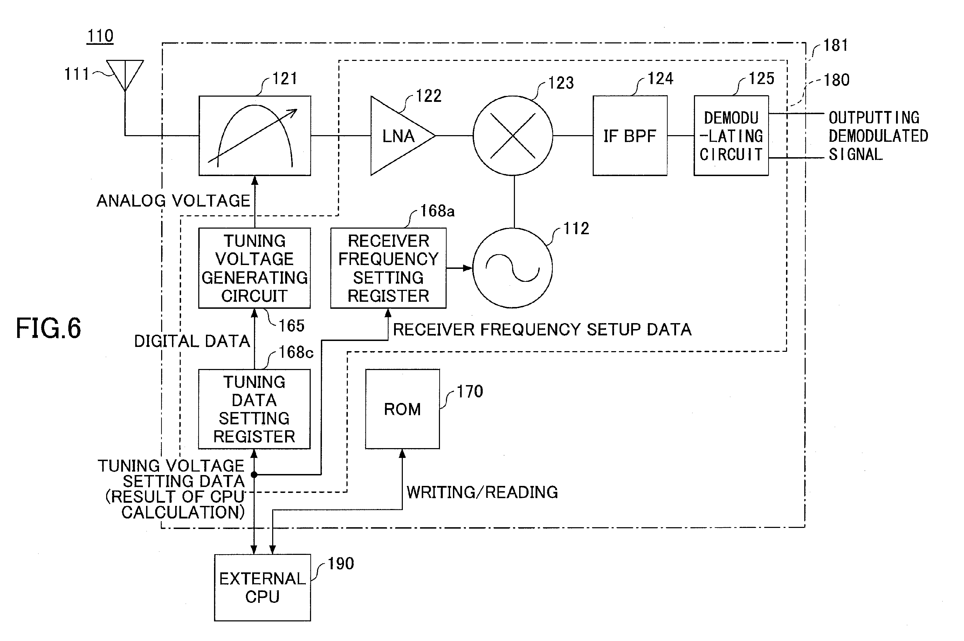

FIG. 6 is a block chart illustrating an exemplary structure of a FM receiver 110. The FM receiver 110 includes an antenna 111, a tuner module 181 and a CPU 190. The tuner module 181 includes a tuning circuit 121, a receiving IC 180, a ROM_IC 170 and a peripheral circuit component. In the exemplary FM receiver 110, the CPU 190 outside the tuner module 181 writes combined data of the digital data indicative of the receiver frequency and the tuning digital data corresponding to the receiver frequency in the ROM_IC 170. These combined data are copied from the ROM_IC 170 to the CPU 190. The CPU 190 processes software to calculate tuning voltage setting data corresponding to the desired receiver frequency. The calculated tuning voltage setting data are sent to the receiving IC 180 together with receiver frequency setup data. As described, in the exemplary FM receiver 110, data are not directly exchanged between the receiving IC 180 and the ROM_IC 170. Instead, the data are always exchanged via the CPU 190.

On the contrary, with the embodiment, the tuning voltage setting data are calculated inside the receiving IC 80 to thereby enable reducing man-hours (a user) in designing the software for the CPU 190. Further, since the memory 70 is integrated in the receiving IC 80, an installing area and a wiring number can also be reduced. In order to realize these features, a calculation process of the tuning voltage setting data by the software is performed by hardware, i.e., the computing unit 67. In order to easily realize the above hardware, it is requested to simplify the formula for calculation the tuning digital data corresponding to the desired receiver frequency. With the embodiment of the present invention, by storing the coefficient data for calculating the tuning voltage setting data as the tuning digital data, the formula can be simplified.

Referring to FIG. 1, an embodiment of the present invention is described in detail.

The receiver 10 includes an antenna 11, and the tuning circuit 21 for selecting the RF signal received by the antenna 11 and causing it to pass through the receiving IC 80 and the external CPU 90. For example, the tuning circuit 21 and the receiving IC 80 form a tuner module in the receiver 10. For example, the receiver 10 may be a FM receiver receiving electric waves in the FM broadcast band. The receiver 10 and the receiving IC 80 may receive electric waves in another frequency band as long as a tuning circuit is used in receiving the electric waves. A checking device 100 illustrated in FIG. 1 is provided to check the performance of the receiving IC 80 and/or the receiver 10.

The tuning circuit 21 performs a tuning operation of extracting a high frequency signal in the FM broadcast band which is a frequency band to be received from the high frequency signal generated by receiving electric waves by the antenna 11. The tuning circuit 21 can change the frequency band of the signal components, which are extracted from the high frequency signal generated by receiving the electric waves by the antenna 11, by the tuning voltage input from the outside. Said differently, the tuning circuit 21 can extract the signal components of the frequency band corresponding to the tuning voltage from the high frequency signal generated by receiving the electric waves by the antenna 11.

For example, the tuning circuit 21 includes at least a parallel circuit including two variable capacitance diodes whose cathodes are connected and an inductor arranged in parallel. The tuning voltage generated by the DA converter 65 in response to the desired receiver frequency is supplied to a connecting point between the cathodes of the two variable capacitance diodes.

The receiving IC 80 includes a FM low noise amplifier 22 being an amplifying unit for outputting an amplified signal obtained by amplifying the input high frequency signal, the frequency converting unit (a FM mixer 23) for converting an amplified signal output from the FM low noise amplifier 22 to an intermediate frequency signal, the local oscillating circuit 12, the IF bandpass filter 24, a demodulating circuit 25 which can demodulate a FM receiving signal output from the frequency converting unit, DA converters 14 and 15 for converting between digital and analog an output signal from the demodulating circuit 25, and a tuning voltage generating unit 16.

The FM low noise amplifier 22 outputs the amplified signal which is obtained by amplifying the high frequency signal input via the tuning circuit 21 outside the receiving IC at a predetermined amplifying rate.

The FM mixer 23 outputs an intermediate frequency signal by mixing the amplified signal output from the FM low noise amplifier 22 and a local oscillating frequency signal output from the local oscillating circuit 12.

A part or all of the tuning circuit 21 may exist outside or inside the receiving IC 80. Further, the tuning circuit 21 may exist in a former stage or a later stage of the FM low noise amplifier 22. The tuning circuit 21 may be formed by an element or a circuit equivalent to or substitutable for the variable capacitance diodes and the inductor.

The IF bandpass filter 24 extracts a signal component of the desired channel from the intermediate frequency signal output from the FM mixer 23.

The demodulating circuit 25 decodes the output signal provided with the filtering process and output from the IF bandpass filter 24 to a monaural signal or right and left side audio signals. The DA converter 14(15) converts the audio signal in a digital format converted by the demodulating circuit 25 to an audio signal in an analog format.

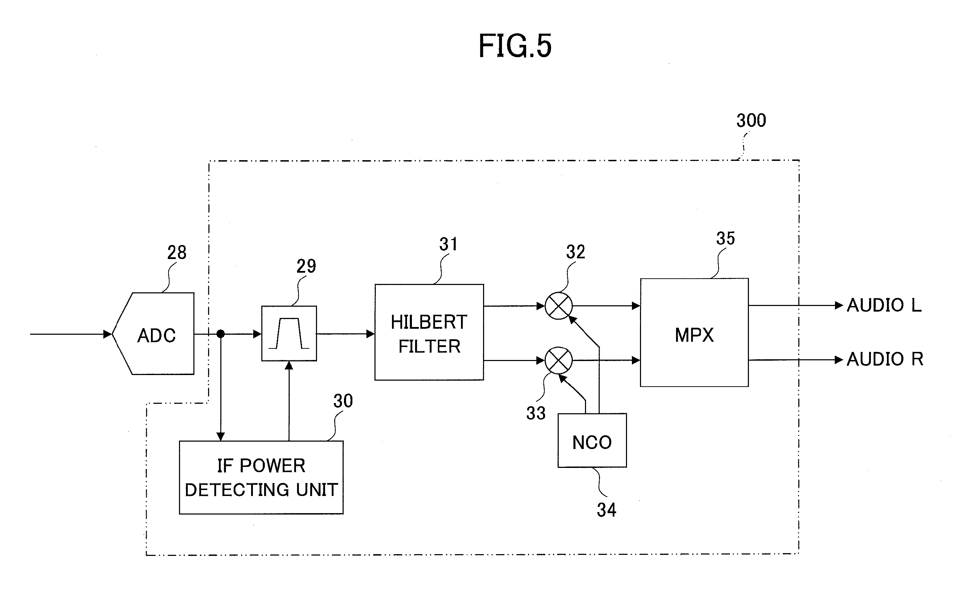

FIG. 5 is a block chart illustrating an exemplary structure of the demodulating circuit 25. The demodulating circuit 25 is a demodulating circuit for demodulating based on the intermediate frequency signal. However, the structure may not be limited to the structure illustrated in FIG. 5.

The demodulating circuit 25 includes an AD converting unit for converting the output signal provided with the filtering process to the digital signal and output from the IF bandpass filter 24 and a digital demodulating unit for demodulating the digital signal output from the AD converting unit. FIG. 5 illustrates an AD converter (ADC) 28 as an AD converting unit and a digital demodulating unit 300 as a digital demodulating unit. The digital demodulating unit 300 includes a filter unit for limiting a band through which the digital signal can pass and a power distribution detecting unit for detecting power distribution of the intermediate frequency signal as a main structure.

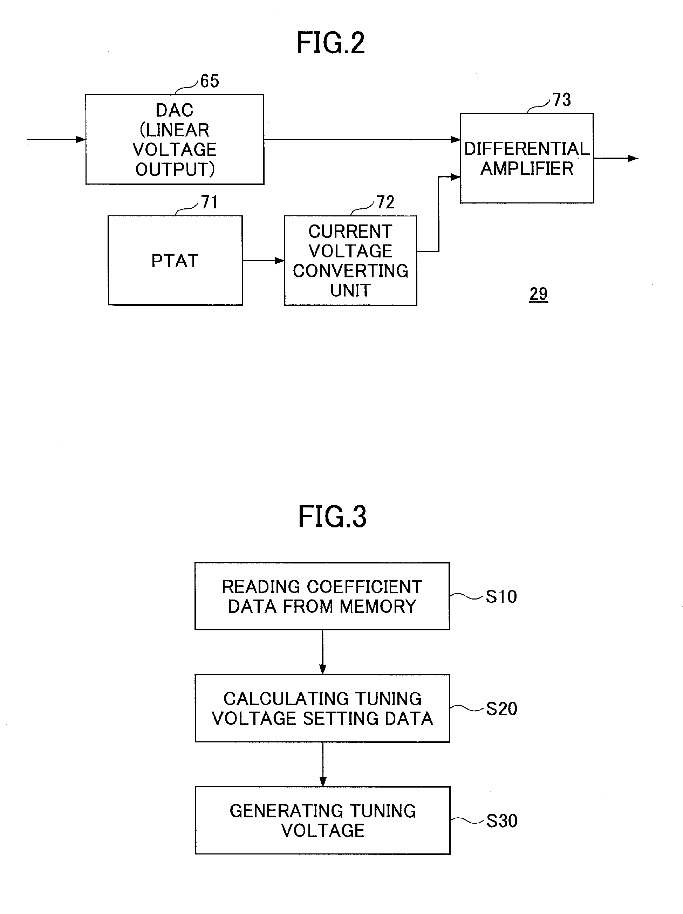

The filter unit includes plural passbands having mutually different bandwidths for extracting an output signal including a signal component of the desired channel selected by a user or the like from the digital signal. FIG. 2 illustrates a band-limit filter 29 as a filter unit.

The power distribution detecting unit detects power distribution of the signal component of the desired channel and power distribution of the signal component of an adjacent channel. FIG. 5 illustrates an IF power detecting unit 30 as the power distribution detecting unit.

Based on the power distribution of the signal component of the desired channel detected by the IF power detecting unit 30 and the power distribution of the signal component of the adjacent channel detected by IF power detecting unit 30, the passband of the band-limit filter 29 is switched over to the passband selected from the plural passbands.

Based on the power distribution of the signal component of the desired channel and the power distribution of the signal component of the adjacent channel, the passband of the band-limit filter 29 is switched over. Therefore, the passband of the band-limit filter 29 can be switched over to a passband in which the power of the signal component of the desired channel is not reduced and the power of the signal component of the adjacent channel is not increased. Thus, it is possible to simultaneously improve a receiving performance of the desired channel and reduce noise interference.

Referring to FIG. 5, a Hilbert filter 31 provides a Hilbert conversion to the output signal provided with the filtering process and output from the band-limit filter 29. Digital mixers 32 and 33 supply an output signal generated by multiplying the output signal from the Hilbert filter 31 by a discrete sinusoidal signal which is output from a numerical control oscillator (NCO) 34 to a MPX 35. The MPX 35 is a multiplex circuit. The MPX 35 decodes to obtain the right and left side audio signals.

Referring to FIG. 1, the tuning voltage generating unit 16 generates a tuning voltage by providing a DA conversion to tuning voltage setting data which are to set the tuning voltage for controlling the tuning operation of the tuning circuit 21.

The tuning voltage generating unit 16 forms the DA converter 65. The tuning voltage generating unit 16 includes, as a unit for setting an analog output voltage of the DA converter 65, the computing unit 67 for outputting digital data to the DA converter 65, registers 68 (68a, 68b, 68c and 68d) in which the digital data are stored, a memory for storing the digital data and a read only logical circuit 69 for reading the digital data from the memory 70 and outputting the read digital data to the register 68b. The external CPU 90 is a central processing unit provided outside the receiving IC 80. The computing unit 67 and the read only logical circuit 69 may be realized by a hardware circuit. For example, the read only logical circuit 69 may be formed by a hard IP (Intellectual Property). The memory 70 is a rewritable read only memory. The memory may be, for example, an EEPROM or a flash memory.

The output from the DA converter 65 may be supplied as a backward voltage to the variable capacitance diode of the tuning circuit 21. The capacitance value of the variable capacitance diode is changed by a backward voltage. The variable capacitance diode is resonated with the inductor connected in parallel to thereby function as a bandpass filter having a variable frequency. The bandpass filter selects a high frequency signal in the FM broadcast band and makes the selected high frequency signal pass through. Said differently, the tuning frequency of the tuning circuit 21 is controlled to change in conformity with the output voltage from the DA converter 65 which changes relative to the input tuning voltage setting data.

The tuning voltage setting data input to the DA converter 65 changes in response to the digital data stored in the register 68. The register 68 includes the registers 68a, 68b and 68c. The first register 68a stores the digital data (receiver frequency setup data) indicative of the desired receiver frequency. The second register 68b stores one or plural digital data sets (coefficient data) indicative of coefficients of terms of a computing equation (hereinafter, referred to as a computing equation E) for calculating the tuning voltage setting data corresponding to the desired receiver frequency. The third register 68c stores correction tuning data. The digital data stored in the registers 68a and 68c are supplied from the external CPU 90. The coefficient data stored in the register 68b are read from the memory 70 by the read only logical circuit 69 and supplied to the register 68b.

The computing unit 67 calculates the tuning voltage setting data corresponding to the desired receiver frequency in conformity with the computing equation E in which the receiver frequency setup data stored in the register 68a and the coefficient data stored in the register 68b are reflected. The computing unit 67 calculates the tuning voltage setting data corresponding to the desired receiver frequency by substituting the tuning voltage setting data corresponding to the desired receiver frequency with the corresponding portion of the computing equation E which has the coefficient data read from the memory 700 and stored into the register 68b.

Formula 2

$$D_a = \frac{D_2 - D_1}{F_2 - F_1} F_a - \frac{D_2 - D_1}{F_2 - F_1} F_1 + D_1 \qquad \cdots (2)$$

Formula 3

$$\frac{D_2 - D_1}{F_2 - F_1} = A \qquad \cdots (3)$$

Formula 4

$$-\frac{D_2 - D_1}{F_2 - F_1} F_1 + D_1 = B \qquad \cdots (4)$$

Formula 5

$$D_a = A \cdot F_a + B \qquad \cdots (5)$$

The computing equation E is obtainable by deforming the above Formula 1. Formula 2 is obtainable by developing the right side of Formula 1. If the coefficient of the first term on the right side of Formula 2 is represented by a first coefficient "A" as in Formula 3 and if the coefficients of the first and second terms on the right side of Formula 2 are represented by a second coefficient "B" as in Formula 4, Formula 1 can be transformed to Formula 5. Formula 5 corresponds to the computing equation E.

Therefore, a relationship between the receiver frequency and the tuning digital data is represented by Formula 5 being a linear function having the coefficients A and B, and the values of the coefficients A and B are determined by Formula 3 and Formula 4. For example, when the coefficient data related to the coefficients A and B previously obtained using Formula 3 and Formula 4 are stored in the memory 70, the computing unit 67 can calculate the tuning voltage setting data (i.e., the tuning digital data $D_a$) corresponding to the desired receiver frequency $F_a$ in conformity with Formula 5 based on the coefficient data of the coefficients A and B read from the memory 70 and stored in the register 68b by the read only logical circuit 69 and the receiver frequency setup data supplied from the external CPU 90 to the register 68a and stored in the register 68a.

By using the coefficients A and B, the computing unit 67 performing the calculation of Formula 5 may be formed by a circuit having one multiplier and one adder only. Therefore, a small hardware logic circuit is realized by Formula 5 in comparison with Formula 1 requiring one division, one multiplication, three subtractions and one addition. By realizing using the hardware, the calculation by the software in the external CPU 90 becomes unnecessary.

The digital data calculated by the computing unit 67 using Formula 5 are input to the DA converter 65. The DA converter 65 controls the tuning frequency by converting the input tuning digital data $D_a$ to the tuning voltage being the analog voltage, outputting the converted tuning digital data and supplying the analog voltage to the tuning circuit 21.

Further, the electrically rewritable read only memory (e.g., an EEPROM) may be formed inside the receiving IC 80, allowing the coefficient data that were to be stored in the register 68b to instead be stored in the memory 70. In this case, the coefficient data stored in the memory 70 may be stored in the register 68b at a time of powering the receiving IC 80 or resetting the receiving IC 80 (the resetting including releasing from the resetting), for example. With this, it is possible to reduce a number of times of reading the data from the memory 70.

For example, the coefficient data stored in the register 68b can be used even if the receiver frequency $F_a$ changes. Then, the coefficients A and B may be preferably stored in the memory 70 which can be electrically rewritten, the coefficients A and B may preferably be returned to the register 68b once at the time of powering or resetting the receiving IC as a part of the superheterodyne receiver apparatus. The coefficient data can be copied (read) by the read only logical circuit 69 from the memory 70 to the register 68b without going through the external CPU 90. After copying (reading) the coefficient data from the memory 70 to the register 68b, as long as the data stored in the register do not disappear by resetting or the like, it is unnecessary to change the coefficient data stored in the register 68b.

Further, the register 68a storing the digital data representing the desired receiver frequency is an oscillating frequency controlling unit for controlling the oscillating frequency of the local oscillating frequency signal of the local oscillating circuit 12 and can be used irrespective of a calculating method of the tuning voltage setting data being the tuning digital data.

The coefficient data are written in the memory 70 under, for example, control of the external CPU 90 or the checking device 100 in a manufacturing process of the receiving IC 80 or the receiver 10. In a stage that the receiving IC 80 or the receiver 10 is used by the user, control and an operation for calculating the tuning digital data can be done inside the receiving IC 80 and the external CPU 90 so that the software may be used.

Therefore, within the embodiment discussed herein, the control and the operation for calculating the tuning digital data are completed inside the receiving IC 80. Therefore, without a direct control from the outside such as the external CPU 90, the tuning frequency can be set to be the desired receiver frequency. Then, the external CPU and the degree of dependence can be minimized to thereby enable performing the RF tuning without increasing time and cost for designing the software.

Meanwhile, it is preferable that the coefficient data previously stored in the memory 70 are determined for each receiving IC 80 having the memory 70 or for each receiver 10 and stored in the memory 70. There are scatterings (errors) in properties (e.g., DA conversion accuracy of the DA converter 65, an output property of a predetermined output value changing depending on the predetermined input value in the receiving IC 80, and a tuning frequency of the tuning circuit 21 changing in response to the tuning voltage) in the receiving IC 80 and the receiver 10. Therefore, if the tuning voltage setting data are input to the DA converter 65, the tuning voltage output from the DA converter may differ, or the tuning frequency of the tuning circuit 21 may differ. As such, the properties of the receiving IC 80 or the receiver 10 may differ between the receiving IC 80 and the receiver 10. Therefore, the coefficient data adjusted for each receiving IC 80 or each receiver 10 are stored in the memory 70 of the corresponding receiving IC 80 to thereby obtain Formula 5 conforming to the properties of the receiving IC 80 and the receiver 10. Thus, the tuning frequency can be accurately controlled.

The checking device 100 supplies the correction tuning data to the register 68c as a previous step for making the memory 70 store the coefficient data in a case where the coefficient data adjusted for each receiving IC 80 or each receiver 10 are not stored in the corresponding memory 70 (e.g., in a case before shipment of the receiving IC). By switching an input route to the DA converter 65 from a side of the computing unit 67 to a side of the register 68c, the correction tuning data stored in the register 68c are input into the DA converter 65 as the tuning voltage setting data.

The DA converter 65 controls the tuning frequency by converting the input tuning digital data $D_a$ to the tuning voltage being the analog voltage, outputting the converted tuning digital data, and supplying the analog voltage to the tuning circuit 21.

By controlling the tuning frequency with the correction tuning data, the checking device 100 obtains combined data of the correction tuning data and the receiver frequency obtained by the tuning circuit 21 corresponding to the correction tuning data. Since the checking device 100 calculates the coefficients A and B using Formula 3 and Formula 4, at least two sets of the combined data of the correction tuning data and the receiver frequency obtained by the tuning circuit 21 corresponding to the correction tuning data. The external CPU 90 calculates the coefficients A and B using Formula 3 and Formula 4. The coefficients A and B may be performed before shipment of the receiving IC 80 by the CPU of the checking device or after installing the receiving IC 80 in a product such as the receiver 10 by the checking device 100 or a CPU (e.g., the external CPU 90) integrated in the product.

The checking device 100 or the external CPU 90 writes the coefficient data related to the coefficients A and B calculated using Formula 3 and Formula 4 in the memory 70.

When the receiving IC 80 is powered or reset (the resetting including releasing from the resetting), the read only logical circuit 69 operated by an internal control sends the coefficient data related to the coefficients A and B written in the memory 70 to the register 68b. If the coefficient data are read from the memory 70 and stored in the register 68b at the time of powering or resetting the receiving IC as a part of the superheterodyne receiver apparatus, it is unnecessary to copy (read) the coefficient data from the memory 70 to the register 68b at every switching to the desired receiver frequency $F_a$.

On the other hand, in a case where electric waves in the FM broadcast band are received while the coefficient data are already stored in the memory 70, the computing unit 67 calculates tuning voltage setting data for selecting the electric waves of the receiver frequency based on setup data of the receiver frequency stored in the register 68a and the coefficient data stored in the register 68b. By storing the coefficient data stored in the ROM 70 in the register 68b, the tuning voltage setting data may be input to the DA converter 65.

Even in a case where the electric waves in the FM broadcast band are received while the coefficient data are stored in the memory 70, in a manner similar to the above, the coefficient data are read from the ROM 70 and stored in the register 68b at the time of powering or resetting the receiving IC as a part of the superheterodyne receiver apparatus, it is unnecessary to copy (read) the coefficient data from the ROM 70 to the register 68b.

The D/A conversion unit for converting the tuning voltage setting data calculated by the computing unit 67 to a tuning voltage (an analog voltage) corresponding to the desired receiver frequency may include a correction unit for correcting the tuning voltage generated by the DA converter 65 so as to correct the variation caused by the temperature generated due to the tuning frequency of the tuning circuit 21, in addition to the DA converter 65. With this, even if atmospheric temperature varies, it is possible to suppress attenuation of the high frequency signal (an RF signal) caused by variation of the tuning frequency in the tuning circuit 21.

FIG. 2 is a block chart of a compensation circuit illustrating an exemplary correction unit for correcting the tuning voltage. The D/A conversion unit includes the compensation circuit in addition to the DA converter 65. The compensation circuit includes a PTAT (Proportional To Absolute Temperature) 71, a current voltage converting unit 72 and a differential amplifier 73.

The DA converter 65 outputs a linear analog voltage to the input of the digital data. The PTAT 71 is a current output unit for outputting a current in proportion to an absolute temperature. The current voltage converting unit 72 converts, in consideration of temperature properties of the tuning circuit 21, the output current from the PTAT 71 to a tuning voltage based on a temperature coefficient indicative of the temperature properties of the tuning frequency in the tuning circuit 21 and outputs the converted tuning voltage. Therefore, by inputting the output voltage from the DA converter 65 and the output voltage from the current voltage converting unit 72 and subtracting the output voltages, it is possible to output a tuning voltage that underwent the temperature compensation.

The operation of the receiving IC 80 can be illustrated in FIG. 3. FIG. 3 is a flowchart illustrating an exemplary receiving method of the embodiment of the present invention.

In step S10 of reading the coefficient data, the read only logical circuit 69 reads the coefficient data from the memory 70. The coefficient data stored in the memory 70 represent coefficients (digital data) of the terms in a formula for computation (e.g., Formula 5) for calculating the tuning voltage setting data corresponding to the desired receiver frequency.

In step S20, the computing unit 67 calculates the tuning voltage setting data corresponding to the desired receiver frequency in conformity with the formula for computation for calculating the tuning voltage setting data based on the coefficient data read out of the memory in step S10 of reading the coefficient data.

In step S30 of generating the tuning voltage, the tuning voltage setting data calculated in step S20 of calculating the tuning voltage setting data undergoes a DA conversion to thereby generate the tuning voltage corresponding to the desired receiver frequency.

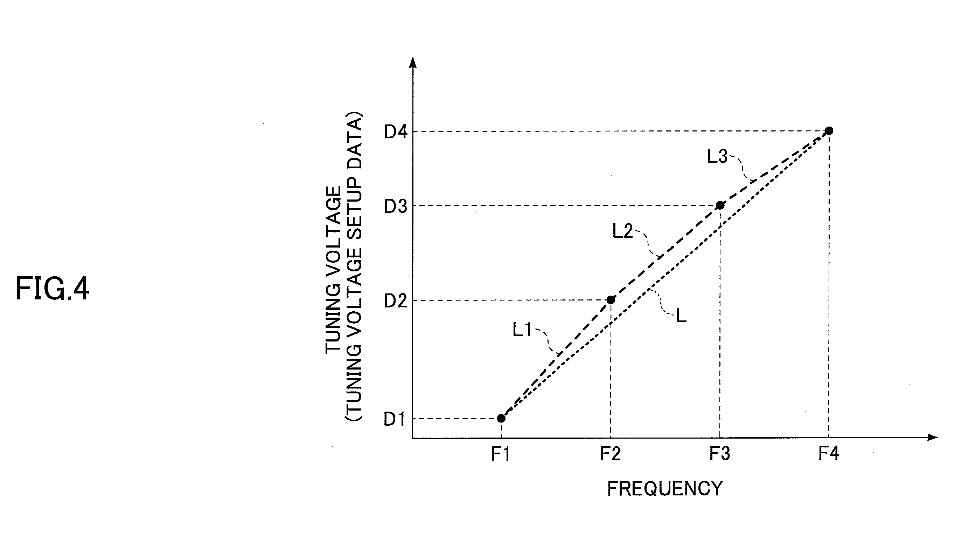

FIG. 4 illustrates a relationship between the receiver frequency and the tuning voltage setting data. Within the above-described embodiment, the number of the computing equations E for calculating the tuning voltage setting data corresponding to the desired receiver frequency is one. However, if a relationship between the desired receiver frequency and the tuning voltage setting data is not proportional (is expressed by a curve in a graph) as illustrated in FIG. 4, the relationship can be approximated by a regression line L. However, if the tuning voltage setting data is calculated based on the regression line L, an error becomes great. In this case, the band of the receiver frequency is divided into plural bands and the computing equation E may be used for each divided band. Referring to FIG. 4, the computing equation E is expressed by three regression lines L1, L2 and L3. The memory 70 stores the coefficient data of the computing equations expressed by the regression lines and calculated for each regression line in conformity with Formula 3 and Formula 4 and frequency data F2 and F3 being boundaries of the regression lines L1, L2 and L3. The computing unit 67 may calculate the tuning voltage setting data by selecting the coefficient data based on whether the desired receiver frequency $F_a$ is positioned before or after the frequency F2 or F3 and using the selected coefficient data in Formula 5 in a manner similar to the above.

Further, the case where the coefficients of the computing equation E are stored in the memory 70 is described in the above embodiment. However, it is possible to easily calculate the tuning voltage setting data in a manner similar to the above by realizing the calculation process with the computing equation E using the computing unit as hardware and storing the calculated coefficient data in the memory 70.

Although the invention has been described with respect to specific embodiments for a complete and clear disclosure, the appended claims are not to be thus limited but are to be construed as embodying all modifications and alternative constructions that may occur to one skilled in the art that fairly fall within the basic teachings herein set forth.

This patent application is based on Japanese Priority Patent Application No. 2009-216484 filed on September 18, 2009, the entire contents of which are hereby incorporated herein by reference.

EXPLANATION OF REFERENCE SIGNS

10, 110 :    FM receiver

11, 111 :    antenna

12, 112 :    local oscillating circuit

14 :    DA converter for converting left side signal

15 :    DA converter for converting right side signal

16 :    tuning voltage generating unit

21 :    tuning circuit

22, 122 :    FM low noise amplifier

23, 123 :    FM mixer

24, 124 :    FM IF bandpass filter

25, 125 :    demodulating circuit

28 :    converter

29 :    band-limit filter

30 :    IF power detecting unit

31 :    Hilbert filter

| | |
|---|---|
| 32, 33 : | digital mixer |
| 34 : | numerical control oscillator (NCO) |
| 35 : | multiplex circuit (MPX) |
| 65 : | DA converter |
| 66 : | switching circuit |
| 67 : | computing unit |
| 68, 168 : | register |
| 69 : | read only logical circuit |
| 70, 170 : | memory |
| 71 : | PTAT |
| 72 : | current voltage converting unit |
| 73 : | differential amplifier |
| 80 : | receiving IC |
| 90, 190 : | CPU |
| 100 : | checking device |
| 180 : | receiving IC (radio IC) |
| 181 : | tuner module |
| 300 : | digital demodulating unit |

**Claims**

1. A superheterodyne receiver apparatus comprising:

    a tuning circuit including a voltage-variable capacitance element and an inductance element for selecting a high frequency signal and receiving the selected high frequency signal;
    a frequency converting unit configured to convert the high frequency signal to an intermediate frequency signal;
    an electrically rewritable read only memory configured to electrically rewrite data;
    a calculation unit configured to calculate tuning voltage setting data for setting a tuning voltage corresponding to a desired receiver frequency using a formula whose coefficients are the data in the electrically rewritable read only memory; and
    a D/A conversion unit configured to convert the tuning voltage setting data to the tuning voltage.

2. The superheterodyne receiver apparatus according to claim 1, further comprising:

    a first register configured to store digital data indicative of the desired receiver frequency; and
    a second register configured to store the data being the coefficients read from the electrically rewritable read only memory,
    wherein the calculation unit calculates the tuning voltage setting data using the formula to which the digital data stored in the first register and the data stored in the second register are applied.

3. The superheterodyne receiver apparatus according to claim 1,
wherein the data being the coefficient are read out of the electrically rewritable read only memory at a time of powering or resetting a part of the superheterodyne receiver apparatus.

4. The superheterodyne receiver apparatus according to claim 1, further comprising:

a plurality of superheterodyne receiver apparatus units,
wherein the data being the coefficients are determined for each one of the superheterodyne receiver apparatus units respectively including electrically rewritable read only memory units and stored in the respective electrically rewritable read only memory units.

5. The superheterodyne receiver apparatus according to claim 1, further comprising:

a demodulating circuit configured to demodulate in a digital method based on the intermediate frequency signal.

6. The superheterodyne receiver apparatus according to claim 1,
wherein the high frequency signal is in a FM broadcast band.

7. The superheterodyne receiver apparatus according to claim 1,
wherein the D/A conversion unit includes a correction unit for correcting the tuning voltage so as to correct variation caused by a temperature generated due to a tuning frequency of the tuning circuit to which the tuning voltage is supplied.

8. A superheterodyne receiving method used for converting a high frequency signal to an intermediate frequency, the superheterodyne receiving method comprising:

calculating tuning voltage setting data for setting a tuning voltage corresponding to a desired receiver frequency using a formula whose coefficients are data in an electrically rewritable read only memory; and converting the tuning voltage setting data to the tuning voltage.

9. A semiconductor integrated circuit for a superheterodyne receiver apparatus that includes a tuning circuit including a voltage-variable capacitance element and an inductance element for selecting high frequency signals and receiving the selected high frequency signals, and plural frequency converting units configured to convert the high frequency signals to intermediate frequency signals, the frequency converting units being integrated, the semiconductor integrated circuit comprising:

an electrically rewritable read only memory configured to electrically rewrite data;
a calculation unit configured to calculate tuning voltage setting data for setting a tuning voltage corresponding to a desired receiver frequency using a formula whose coefficients are the data in the electrically rewritable read only memory; and
a D/A conversion unit configured to convert the tuning voltage setting data to the tuning voltage.

10. The semiconductor integrated circuit according to claim 9, further comprising:

a first register configured to store digital data indicative of the desired receiver frequency; and
a second register configured to store the data being the coefficients read from the memory,
wherein the calculation unit calculates tuning voltage setting data using the formula to which the digital data stored in the first register and the data stored in the second register are applied.

11. The semiconductor integrated circuit according to claim 9,
wherein the data being the coefficient are read out of the electrically rewritable read only memory at a time of powering or resetting the semiconductor integrated circuit.

12. The semiconductor integrated circuit according to claim 9, further comprising:

semiconductor integrated circuit units,
wherein the data being the coefficients are determined for each one of the semiconductor integrated circuit units respectively including electrically rewritable read only memory units and stored in the respective electrically rewritable read only memory units.

13. The semiconductor integrated circuit according to claim 9, further comprising:

   a demodulating circuit configured to demodulate in a digital method based on the intermediate frequency signal.

14. The semiconductor integrated circuit according to claim 9,
   wherein the high frequency signal is in a FM broadcast band.

15. The semiconductor integrated circuit according to claim 9,
   wherein the D/A conversion unit includes a correction unit for correcting the tuning voltage so as to correct variation caused by a temperature generated due to a tuning frequency of the tuning circuit to which the tuning voltage is supplied.

EP 2 479 900 A1

FIG.1

# FIG.2

```
        ┌─────────────┐ 65                              ┌──────────────┐ 73
        │    DAC      │                                 │              │
   ──────→│  (LINEAR   │────────────────────────────────→│ DIFFERENTIAL │──────→
        │  VOLTAGE    │                                 │  AMPLIFIER   │
        │  OUTPUT)    │                                 │              │
        └─────────────┘                                 └──────────────┘
        ┌─────────────┐ 71    ┌─────────────┐ 72
        │             │       │   CURRENT   │
        │    PTAT     │──────→│   VOLTAGE   │───────┘
        │             │       │ CONVERTING  │                             29
        │             │       │    UNIT     │
        └─────────────┘       └─────────────┘
```

# FIG.3

```
        ┌─────────────────────────┐
        │   READING COEFFICIENT   │
        │   DATA FROM MEMORY      │────S10
        └─────────────────────────┘
                    │
                    ↓
        ┌─────────────────────────┐
        │   CALCULATING TUNING    │
        │  VOLTAGE SETTING DATA   │────S20
        └─────────────────────────┘
                    │
                    ↓
        ┌─────────────────────────┐
        │    GENERATING TUNING    │
        │        VOLTAGE          │────S30
        └─────────────────────────┘
```

FIG.4

# FIG.5

EP 2 479 900 A1

**FIG.6**

EP 2 479 900 A1

## INTERNATIONAL SEARCH REPORT

| | International application No. |
| --- | --- |
| | PCT/JP2010/064296 |

**A. CLASSIFICATION OF SUBJECT MATTER**
*H04B1/26*(2006.01)i, *H03J5/02*(2006.01)i, *H04B1/10*(2006.01)i, *H04B1/18*
(2006.01)i

According to International Patent Classification (IPC) or to both national classification and IPC

**B. FIELDS SEARCHED**

Minimum documentation searched (classification system followed by classification symbols)
H04B1/26, H03J5/02, H04B1/10, H04B1/18

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 5-48392 A (Sharp Corp.), 26 February 1993 (26.02.1993), claim 1; paragraphs [0051] to [0053]; fig. 6 (Family: none) | 1-15 |
| Y | JP 2000-174652 A (Alpine Electronics, Inc.), 23 June 2000 (23.06.2000), paragraphs [0010], [0041] (Family: none) | 1-15 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 29 September, 2010 (29.09.10) | 12 October, 2010 (12.10.10) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

18

**EP 2 479 900 A1**

**REFERENCES CITED IN THE DESCRIPTION**

**Patent documents cited in the description**

- JP H0548392 B
- JP 2009216484 A